# EUROPEAN PATENT SPECIFICATION

(11) **EP 1 722 409 B1**
(45) Date of publication and mention of the grant of the patent: **08.08.2012**
(21) Application number: 05010048.6
(22) Date of filing: 09.05.2005
(51) Int. Cl.: H01L 21/607, B23K 20/00

(54) **Wire bonding method**
Verfahren zum Drahtverbinden
Méthode de connexion de fils

(43) Date of publication of application: 15.11.2006
(73) Proprietor: KAIJO CORPORATION, Tokyo (JP)
(72) Inventor: Shirato, Mizuho, Hamura-shi Tokyo (JP); Fujisawa, Hiromi, Hamura-shi Tokyo (JP); Akita, Tadahisa, Hamura-shi Tokyo (JP)
(74) Representative: Schmauder, Klaus Dieter

(56) References cited:
- EP-A- 1 422 014
- US-A1- 2002 137 327
- US-A1- 2005 092 815
- PATENT ABSTRACTS OF JAPAN vol. 016, no. 120 (E-1182), 26 March 1992 (1992-03-26) -& JP 03 289149 A (MATSUSHITA ELECTRIC IND CO LTD), 19 December 1991 (1991-12-19)
- PATENT ABSTRACTS OF JAPAN vol. 014, no. 045 (E-0880), 26 January 1990 (1990-01-26) -& JP 01 276729 A (NEC KANSAI LTD), 7 November 1989 (1989-11-07)

## Description

### BACKGROUND OF THE INVENTION

### 1. Field of the Invention

The present invention relates to a wire bonding method for connecting a first bonding point and a second bonding point through a wire which forms a wire loop having a certain shape and which may be used to manufacture a semiconductor device having such a wire loop incorporated therein.

### 2. Description of the Related Art

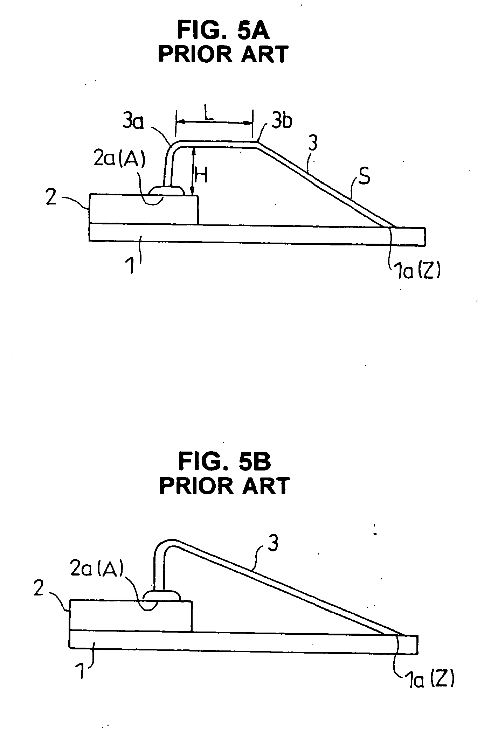

Conventionally, in a process of fabricating a semiconductor device, as shown in Fig. 5A or 5B, wire bonding for connecting a pad 2a or a first bonding point A of a semiconductor chip 2 attached to a lead frame 1 and a lead 1a or a second bonding point Z of the lead frame 1 through a wire 3 has been carried out. Typically, loop shapes of the wire 3 connecting the first and second bonding points A and Z include a trapezoidal shape and a triangular shape shown in Figs. 5A and 5B, respectively, as disclosed, for example, in U.S. Patent No. 6,036,080 or Japanese Patent Application Laid-Open Publication No. 2000-277558.

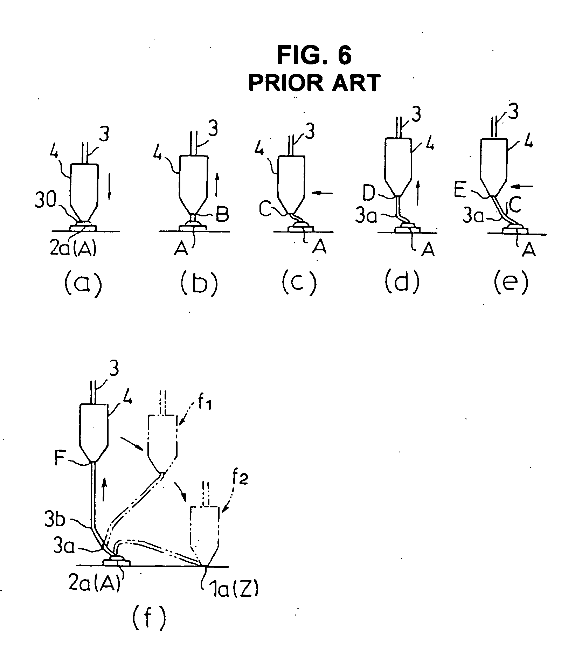

The wire loop having a trapezoidal shape shown in 5A is formed by a sequence of steps as shown in Fig. 6. First, in step (a) of Fig. 6, a capillary 4 through which the wire 3 passes is lowered and a ball 30 which has been formed at a tip end of the wire 3 is bonded to the pad 2a of the chip 2 or first bonding point A. Then, in step (b) of Fig. 6, the capillary 4 is vertically raised to a point B while the wire 3 is delivered. Thereafter, in step (c) of Fig. 6, the capillary 4 is horizontally moved to a point C in a direction opposite from the second bonding point Z.

In general, such an operation of the capillary 4 to be moved in the direction opposite from the second bonding point Z is referred to as a "reverse operation". As a result, the portion of the wire 3 between the points A and C is formed to be inclined and the wire 3 is formed at an upper end of the inclined portion thereof with a kink 3a by a lower end of the capillary 4. The portion of the wire 3 between the points A and C thus delivered corresponds to the height of a neck portion H (or a portion of the wire 3 between the pad 2a and the kink 3a) and will constitute the neck portion H shown in Fig. 5A.

Subsequently, in step (d) of Fig. 6, the capillary 4 is vertically raised to a point D while the wire 3 is delivered. Then, in step (e) of Fig. 6, the reverse operation of the capillary 4 is performed again, i.e. the capillary 4 is horizontally moved to a point E in the direction opposite from the second bonding point Z. As the result of this reverse operation, the wire 3 has another inclined portion extending between the points C and E, and a kink 3b is formed in an upper end of this inclined portion of the wire 3.

This inclined portion of the wire 3 thus delivered will constitute an upper base portion L (or a portion of the wire 3 between the kinks 3a and 3b) of the wire loop having a trapezoidal shape shown in Fig. 5A. Thereafter, in step (f) of Fig. 6, the capillary 4 is vertically raised to a point F so that the wire 3 is delivered by a length corresponding to a long inclined portion S (or a portion of the wire 3 between the kink 3b and the lead 1a) of the wire loop shown in Fig. 5A. Subsequently, the capillary 4 is lowered to the second bonding point Z via positions f₁ and f₂, so that the wire 3 is bonded to the second bonding point Z or the lead 1a.

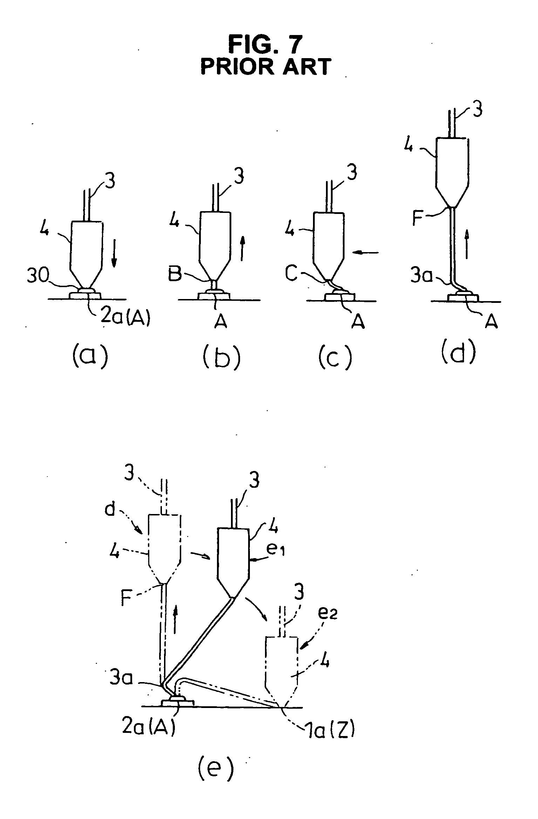

The wire loop having a triangular shape shown in 5B is formed by a sequence of steps as shown in Fig. 7. Since the wire loop having a triangular shape is not provided with an upper base portion (L) unlike the wire loop having a trapezoidal shape described above, in forming the wire loop of a triangular shape, the second reverse operation in steps (d) and (e) of Fig. 6 is not conducted. Therefore, in this instance, a step that corresponds to the steps (d), (e) and (f except for f₁ and f₂) of Fig. 6 is carried out only in step (d) of Fig. 7. More particularly, steps (a), (b) and (c) of Fig. 7 are the same as the steps (a), (b) and (c) of Fig. 6, and after the first reverse operation in step (c) of Fig. 7, the capillary 4 is vertically raised to a point F in step (d) of Fig. 7 while the wire 3 is delivered. Subsequently, in step (e) of Fig. 7, the capillary 4 is moved via positions e₁ and e₂ in a manner similar to that in step (f) of Fig. 6, with the result that the wire 3 is bonded to the second bonding point Z or the lead 1a.

When a wire loop is formed by such a bonding method, a wire connection at the second bonding point Z or on the lead 1a has a crescent shape as the result of crushing with an end portion of the capillary, so that there is a possibility that the wire connection cannot maintain an adequate pull strength.

For this reason, a bonding method called security bonding has been proposed which performs ball bonding with respect to the top of the end-bonded wire. As described in Japanese Patent Application Laid-Open Publication No. 57-12530, this method comprises bonding a wire to a second bonding point, then cutting the wire and forming a ball at the tip of the wire and finally bonding the ball onto the second bonding point again from above. After the ball bonding, the wire is cut as is or end bonding is performed at a point which does not overlap the ball bonded position.

In the aforementioned security bonding method, however, after wire bonding with respect to the second bonding point, the wire is cut and then a ball is newly formed at the tip of the wire, followed by ball bonding with respect to the second bonding point, resulting in the method being time-consuming.

EP-A-1 422 014 discloses a wire bonding method, a wire loop and a semiconductor device, in which a kink is formed in the wire adjacent to the ball bonded to the pad of the semiconductor chip or the first bonding point and the kink is bonded to the top of the ball or the vicinity thereof while a crushed part is formed, so that the major portion of the wire loop is extended from the crushed part toward the second bonding point. This feature shown In EP-A-1 422 014 relates to the first bonding point.

JP 03 289149 A discloses a wire bonding method and a wire loop comprising a technique wherein a folded portion of the wire at the second bonding point is situated on a side of the bonded portion of the wire opposite from the first bonding point.

JP 01 276729A discloses a wire bonding method similar to that of JP 03 289149 A. In the wire bonding method of JP 01 276729A, after bonding wire to the lead or second bonding point, a portion of the wire Is drawn by slightly moving the capillary in a horizontal direction, and then slightly raising the capillary, followed by moving back the capillary toward the semiconductor pellet, whereby the wire is folded back. Thereafter, the thus folded wire is bonded onto the upper surface of the portion of the wire Initially bonded to the lead. Thus, the folded portion of the wire at the second bonding point Is located on a side of the bonded portion of the wire opposite from the first bonding point like in the method in JP 03 289149 A.

US 2005/092815 A1 discloses a wire bonding method similar to those of JP 03 289149 A and JP 01 276729A.

US 2002/137327 A1 discloses a wire bonding method wherein after preliminary bonding at the second bonding point, the capillary is moved upward, then sideways, then lowered, then moved upward, and then the capillary is moved downward. The sideways movement is towards a first bonding point.

### SUMMARY OF THE INVENTION

The present invention has been made in view of the foregoing disadvantages of the prior art.

Accordingly, it is an object of the present invention to provide a wire bonding method capable of forming said wire loop.

In accordance with the present invention, a method of wire bonding between a first bonding point and a second bonding point according to claim 1 is provided.

In the steps of claim 1, the term "at least one point which has been set" means "n" points ("n" indicating a natural number) that are each set on the coordinate axes (X, Y, Z) in advance as a passing point of the capillary during its movement.

In the bonding method of the present invention, the steps (d) and (e) may be alternately repeated a plurality of times, so that a plurality of the additional wire loops are formed and bonded to the second bonding point or to the vicinity thereof.

Further preferred embodiments are defined in claims 2 and 3.

### BRIEF DESCRIPTION OF THE DRAWINGS

These and other objects and many of the attendant advantages of the present invention will be readily appreciated as the same becomes better understood by reference to the following detailed description when considered in connection with the accompanying drawings; wherein:
Fig. 1A is an elevational view showing a semiconductor device manufactured by the method of the present invention and a shape of a wire loop thereof;
Fig. 1B is an elevational view showing an example of a semiconductor device not manufactured by the method of the present invention;
Fig. 2 is a schematic diagram showing the steps for forming a wire loop having a shape shown in Fig. 1A;
Fig. 3 is a schematic diagram showing the steps for forming a wire loop having a shape shown in Fig. 1B;
Figs. 4A and 4B are elevational views each showing an example of a wire loop having a shape like an approach and landing of an aircraft;
Figs. 5A and 5B are elevational views showing conventional wire loops having a trapezoidal shape and a triangular shape, respectively;
Fig. 6 is a schematic diagram showing wire shapes in respective steps in association with the movement of the capillary to form the wire loop of a trapezoidal shape shown in Fig. 5A; and
Fig. 7 is a schematic diagram showing wire shapes in respective steps in association with the movement of the capillary to form the wire loop of a triangular shape shown in Fig. 5B.

### DETAILED DESCRIPTION OF THE INVENTION

Now, a wire loop, a semiconductor device and a wire bonding method will be described hereinafter with reference to the accompanying drawings in which like parts in each of the several figures are identified by the same reference character or numeral.

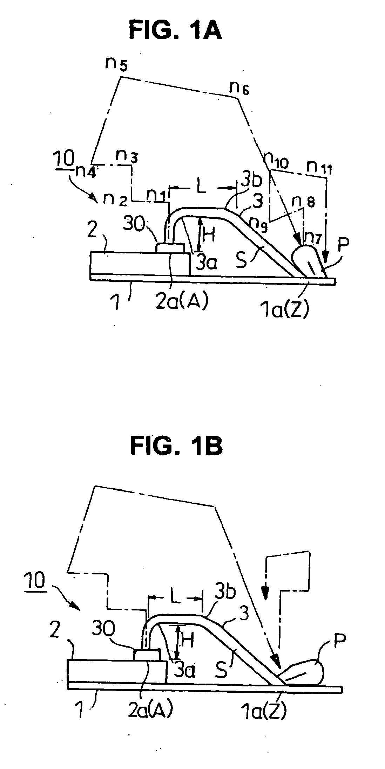

Referring first to Fig. 1A, a wire loop and a semiconductor device 10 having the wire loop manufactured by the method of the present invention is illustrated. In the semiconductor device 10, a semiconductor chip 2 is attached to a lead frame 1 and is provided thereon with a pad 2a which is a first bonding point A. The wire loop of a wire 3 is formed to have a trapezoidal shape in general and includes a neck portion H having a ball 30 bonded to the pad 2a or first bonding point A and a major portion consisting of a horizontal upper portion L and an inclined portion S which has an end bonded to a lead 1a of the lead frame 1 or a second bonding point Z. The horizontal upper portion L of the wire loop is provided at the opposite ends thereof with kinks 3a and 3b.

The above configuration is approximately the same as that of a conventional semiconductor device. However, it has a major feature in an area in the vicinity of the second bonding point Z.

More specifically, after wire bonding at the second bonding point, an additional wire loop is formed without cutting the wire, and bonding is carried out in the vicinity of the second bonding point thereof while part of the wire is crushed. This allows the semiconductor device 10 to have a wire loop provided with an enlarged bonding area at the second bonding point.

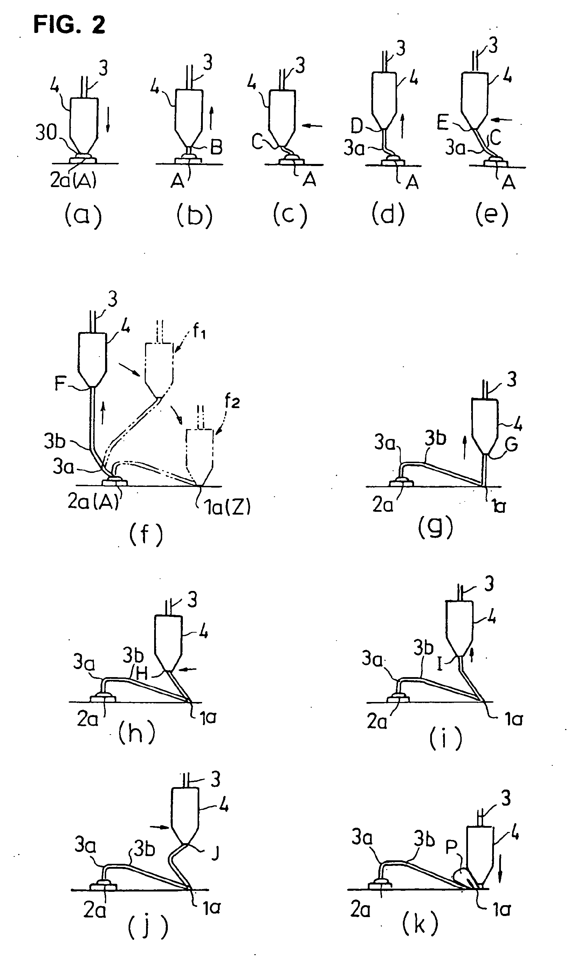

A description will be given next of an embodiment of a wire bonding method according to the present invention for obtaining the semiconductor device 10 shown in Fig. 1A and a shape of the wire loop formed by the method with reference to Fig. 2.

In step (a) of Fig. 2, the capillary 4 is lowered, so that a ball 30 formed on the tip of the wire 3 is bonded to the first bonding point A. Then, in step (b) of Fig. 2, the capillary 4 is vertically raised to a point B while the wire 3 is delivered.

Thereafter, in step (c) of Fig. 2, a reverse operation of the capillary 4 is carried out, i.e. the capillary 4 is horizontally moved in a direction opposite from the second bonding point Z to a point C. As a result, a portion of the wire 3 is slanted from the points A to C, and a kink 3a is formed at an upper end of the slanted portion of the wire 3.

The portion of the wire 3 from the points A to C constitutes the neck portion H (between the pad 2a and the kink 3a) shown in Fig. 1A.

Thereafter, in step (d) of Fig. 2, the capillary 4 is vertically raised to a point D while the wire 3 is delivered. Subsequently, in step (e) of Fig. 2, the capillary 4 is moved horizontally again to a point E in the direction opposite from the second bonding point Z, i.e., another reverse operation is carried out. This renders the wire 3 slanted from the points C to E and having another kink 3b formed at an upper end of this slanted portion of the wire 3.

The portion of the wire 3 from the points C to E constitutes the upper portion L (between the kinks 3a and 3b) of the trapezoid shown in Fig. 1A. Thereafter, in step (f) of Fig. 2, the capillary 4 is vertically raised to a point F so that the wire 3 is delivered by a length which corresponds to the inclined portion S of the wire 3 extending between the kink 3b and the lead 1a. Then, in step (f) of Fig. 2, the capillary 4 is lowered via positions f₁ and f₂ to be located at the second bonding point Z, whereby the wire 3 is bonded to the second bonding point Z.

Though in a conventional wire loop of a trapezoidal shape, the wire 3 is cut here, the capillary 4 is vertically raised to a point G in step (g) of Fig. 2 in the embodiment of the present invention while the wire 3 is delivered. Next, in step (h) of Fig. 2, the capillary 4 is horizontally moved to a point H in the direction toward the first bonding point A so as to move away from the second bonding point Z. This renders the wire 3 slanted from the lead 1a to the point H. Thereafter, in step (i) of Fig. 2, the capillary 4 is vertically raised to a point I while the wire 3 is delivered. Then, in step (j) of Fig. 2, the capillary 4 is horizontally moved to a point J in the direction toward the second bonding point Z. Next, in step (k) of Fig. 2, the capillary 4 is lowered, so that the wire 3 is wire bonded to a vicinity of the second bonding point Z.

It is to be noted that steps (g) to (k) of Fig. 2 correspond to the steps (d) and (e) claimed in claim 1. Performing these steps forms an additional wire loop P and crushes part of the wire 3, to thereby enlarge the bonding area at the second bonding point Z, resulting in a bonding strength at the second bonding point being enhanced. It is to be noted that steps (g) to (k) of Fig. 2, i.e. the claimed steps (d) and (e) may be repeated a plurality of times.

In carrying out the above steps, loop control is performed by setting, in advance, a plurality of passing points n1, n2, n3,... of the capillary 4 during its movement on the coordinate axes (X, Y, Z) as shown in Fig. 1A.

The method of the present invention, while enabling a bonding strength of the same level, ensures a reduction of the time to form a wire loop, as compared with security bonding - a conventionally proposed method - that comprises bonding a wire to the second bonding point, then cutting the wire and newly forming a ball at the tip of the wire, and finally ball bonding to the second bonding point again from above.

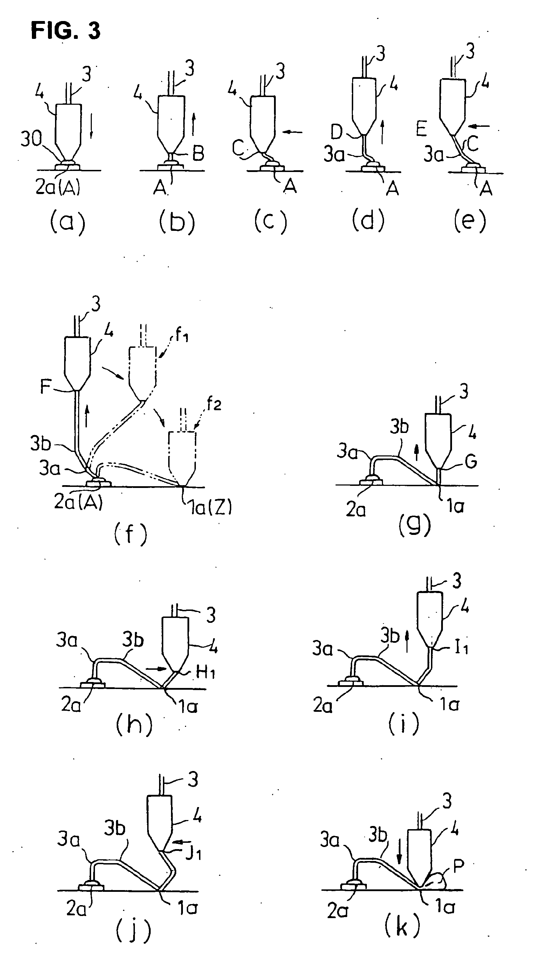

Now, a description will be given of an example of a wire bonding method for obtaining a semiconductor device 10 as shown in Fig. 1B and a shape of the wire loop formed by the method with reference to Fig. 3.

Steps (a) to (f) in Fig. 3 are the same as steps (a) to (f) in Fig. 2, and so their description will be omitted. Differences lie in steps (g) to (k) shown in Fig. 3. More specifically, in step (f) as shown in Fig. 3, the capillary 4 is lowered via positions f₁ and f₂ to be located at the second bonding point Z and the wire 3 is bonded to the second bonding point Z. Thereafter, in step (g) of Fig. 3, the capillary 4 is vertically raised to a point G while the wire 3 is delivered, and in step (h) of Fig. 3, the capillary 4 is horizontally moved to a point H₁ in the direction away from the first bonding point A. This renders the wire 3 slanted. Then, in step (i) of Fig. 3, the capillary 4 is vertically raised to a point I₁ while the wire 3 is delivered. Then, in step (j) of Fig. 3, the capillary 4 is horizontally moved to a point J₁ in the direction toward the first bonding point A (or second bonding point Z). Next, in step (k) of Fig. 3, the capillary 4 is lowered, so that the wire 3 is wire bonded to the second bonding point Z or to the vicinity thereof.

Performing these steps crushes the wire 3 as with steps (g) to (k) of Fig. 2, to thereby enlarge the bonding area at the second bonding point Z, resulting in a bonding strength at the second bonding point being enhanced. It is to be noted that steps (g) to (k) of Fig. 3 may be repeated a plurality of times.

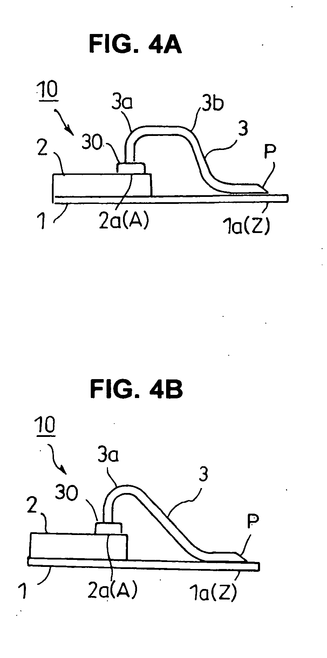

With these steps, it is possible to obtain a wire loop having a shape like an approach and landing of an aircraft as shown in Fig. 4A with part of the wire 3 parallelly touching the second bonding point Z by adjusting an amount of the movement of the capillary, thus enhancing a bonding strength.

Even in the case of a wire loop having a triangular shape as shown in Fig. 5B, it is possible to obtain a wire loop having a shape like an approach and landing of an aircraft as shown in Fig. 4B in a similar manner.

The present invention is applicable to manufacturing of a semiconductor device as a wire bonding method that provides a high wire bonding strength to bonding points and reduces the time to perform wiring.

## Claims

1. A method of wire bonding between a first bonding point (A) and a second bonding point (Z), **characterized in that** the method comprises the steps of:
(a) bonding a wire (3) to the first bonding point (A);
(b) then forming a wire loop extending from the first bonding point (A) to the second bonding point (Z) by performing loop control involving a vertical or horizontal movement of a capillary (4) or a motion of the capillary (4) combining both wherein the capillary (4) passes through at least one point (B. C, D, E, F; n1, n2, n3, n4, n5, n6) which has been set;
(c) thereafter bonding the wire (3) to the second bonding point (Z);
(d) then forming an additional wire loop (P) by delivering the wire (3) while performing loop control involving a vertical and horizontal movement of the capillary (4) wherein the capillary (4) passes through at least another point (G, H, I, J; n8, n9, n10, n11) which has been set, wherein the step (d) consists of vertically raising the capillary (4) to a point (G) while delivering the wire (3), then horizontally moving the capillary (4) in the direction toward the first bonding point (A) to another point (H), thereafter vertically raising the capillary (4) to yet another point (I) while delivering the wire (3), and subsequently horizontally moving the capillary (4) to a further point (J) above the second bonding point (Z), wherein the additional wire loop (P) is formed to have a folded portion located on a side of the second bonding point (Z) nearer to the first bonding point (A); and
(e) subsequently bonding the additional wire loop (P) to the vicinity of the second bonding point (Z) while part of the wire (3) is crushed so that the additional wire loop (P) is formed to have the folded portion extending from the second bonding point (Z) toward the first bonding point (A), whereby the bonding area at the second bonding point (Z) is enlarged.

2. The bonding method as defined in claim 1, wherein the steps (d) and (e) are alternately repeated a plurality of times, so that a plurality of the additional wire loops (P) are formed and bonded to the second bonding point (Z) or to the vicinity thereof.

3. The bonding method as defined In claim 1 or 2, wherein the first bonding point (A) is located on a pad (2a) on a semiconductor chip (2) attached to a lead frame (1) and the second bonding point (Z) is located on a lead (1 a) of the lead frame (1).

## Patentansprüche

1. Verfahren zum Drahtverbinden zwischen einem ersten Verbindungspunkt (A) und einem zweiten Verbindungspunkt (Z), **dadurch gekennzeichnet, dass** das Verfahren die folgenden Schritte umfasst:
(a) Verbinden eines Drahtes (3) mit dem ersten Verbindungspunkt (A);
(b) danach Bilden einer sich vom ersten Verbindungspunkt (A) zum zweiten Verbindungspunkt (Z) erstreckenden Drahtschleife durch Ausführen einer Schleifensteuerung, welche eine vertikale oder horizontale Bewegung einer Kapillare (4) oder eine die beiden kombinierende Bewegung der Kapillare (4) umfasst, wobei die Kapillare (4) mindestens einen vorgewählten Punkt (B, C, D, E, F; n1, n2, n3, n4, n5, n6) durchläuft;
(c) danach Verbinden des Drahtes (3) mit dem zweiten Verbindungspunkt (Z);
(d) danach Bilden einer zusätzlichen Drahtschleife (P) durch Zuführen des Drahtes (3) während des Ausführens einer Schleifensteuerung, welche eine vertikale und horizontale Bewegung der Kapillare (4) umfasst, wobei die Kapillare (4) mindestens einen weiteren vorgewählten Punkt (G, H, I, J; n8, n9, n10, n11) durchläuft, wobei der Schritt (d) die Kapillare (4) während des Bereitstellens des Drahtes (3) vertikal auf einen Punkt (G) anhebt und danach die Kapillare (4) horizontal in Richtung zum ersten Verbindungspunkt (A) hin zu einem weiteren Punkt (H) bewegt und danach die Kapillare (4) während des Zuführens des Drahtes (3) vertikal zu nochmals einem weiteren Punkt (I) anhebt, und die Kapillare (4) anschliessend horizontal zu einem weiteren Punkt (J) oberhalb des zweiten Verbindungspunktes (Z) bewegt, wobei die zusätzliche Drahtschleife (P) gebildet wird derart, dass sie einen gefalteten Abschnitt aufweist, der auf einer Seite des zweiten Verbindungspunktes (Z), die näher zum ersten Verbindungspunkt (A) angeordnet ist, liegt; und
(e) anschliessend Verbinden der zusätzlichen Drahtschleife (P) an die Umgebung des zweiten Verbindungspunktes (Z) wobei ein Teil des Drahtes (3) gestaucht wird derart, dass die zusätzliche Drahtschleife (P) so gebildet wird, dass sich ihr gefalteter Abschnitt vom zweiten Verbindungspunkt (Z) gegen den ersten Verbindungspunkt (A) erstreckt, wobei die Bindungsfläche am zweiten Verbindungspunkt (Z) aufgeweitet wird.

2. Verbindungsverfahren nach Anspruch 1, wobei die Schritte (d) und (e) mehrmals abwechselnd wiederholt werden, so dass eine Vielzahl von zusätzlichen Drahtschleifen (P) gebildet und mit dem zweiten Verbindungspunkt (Z) oder dessen Umgebung verbunden wird.

3. Verbindungsverfahren nach Anspruch 1 oder 2, wobei der erste Verbindungspunkt (A) auf einer Unterlage (2a) auf einem Halbleiterchip (2), der an einem Leiterrahmen (1) befestigt ist, angeordnet ist, und der zweite Verbindungspunkt (Z) auf einem Leiter (1a) des Leiterrahmens (1) angeordnet ist.

## Revendications

1. Procédé de connexion de fils entre un premier point de liaison (A) et un second point de liaison (Z),
procédé **caractérisé par** les étapes suivantes consistant à :
(a) relier un fil (3) au premier point de liaison (A),
(b) puis former une boucle de fil partant du premier point de liaison (A) au second point de liaison (Z) en effectuant une commande de boucle consistant en un mouvement vertical ou horizontal d'un capillaire (4) ou un mouvement du capillaire (4) combinant les deux, le capillaire (4) traversant au moins un point (B, C, D, E, F ; n1, n2, n3, n4, n5, n6) qui a été fixé,
(c) ensuite, fixer le fil (3) au second point de liaison (Z),
(d) puis faire une boucle de fil (P) supplémentaire en fournissant le fil (3) au cours de la commande d'exécution de la boucle consistant en un mouvement vertical et un mouvement horizontal du capillaire (4), le capillaire (4) passant sur au moins un autre point (G, H, I, J ; n8, n9, n10, n11) qui a été ensuite fixé,
l'étape (d) consistant à soulever verticalement le capillaire (4) au point (G) tout en fournissant le fil (3), puis à déplacer horizontalement le capillaire (4) en direction du premier point de liaison (A) jusqu'à un autre point de liaison (H), puis verticalement en soulevant le capillaire (4) vers un autre point (I) tout en fournissant le fil (3) et ensuite en déplaçant horizontalement le capillaire (4) vers l'autre point (J) au-dessus du second point de liaison (Z), la boucle de fil supplémentaire (P) étant formée pour avoir une partie pliée située d'un côté du second point de liaison (Z) plus proche du premier point de liaison (A), et
(e) ensuite fixer la boucle de fil supplémentaire (P) au voisinage du second point de liaison (Z) pendant qu'une partie du fil (3) est écrasée pour que la boucle de fil supplémentaire (P) soit formée avec la partie pliée s'étendant entre le second point de liaison (Z) vers le premier point de liaison (A) agrandissant la surface de liaison du second point de liaison (Z).

2. Procédé de liaison selon la revendication 1,
**caractérisé en ce qu'**
on répète alternativement les étapes (d) et (e) plusieurs fois pour former un ensemble de boucles de fil supplémentaires (P) et les fixer au second point de liaison (Z) ou au voisinage de celui-ci.

3. Procédé de liaison selon la revendication 1 ou 2,
**caractérisé en ce que**
le premier point de liaison (A) est situé sur une patte (2a) d'une puce semi-conductrice (2) fixée à un châssis conducteur (1) et le second point de liaison (Z) est situé sur un conducteur (1a) du châssis conducteur (1).
